# EUROPEAN PATENT APPLICATION

(11) **EP 2 457 969 A1**
(43) Date of publication of application: **30.05.2012**
(21) Application number: 11009368.9
(22) Date of filing: 25.11.2011
(51) Int. Cl.: C09J 7/02

(54) **Surface protective sheet**

(30) Priority: 30.11.2010 JP 2010266027; 11.10.2011 JP 2011223824
(71) Applicant: Nitto Denko Corporation, Ibaraki-shi, Osaka 567-8680 (JP)
(72) Inventor: Hayashi, Keiji, Osaka 567-8680 (JP); Yamato, Jiro, Osaka 567-8680 (JP); Sawazaki, Ryohei, Osaka 567-8680 (JP); Yoshida, Mariko, Osaka 567-8680 (JP)
(74) Representative: Müller-Boré & Partner Patentanwälte

(57) **Abstract**

Provided is a surface protective sheet which satisfactorily adheres even to a coated surface having a rough surface, and not only does not cause an adhesive residue that can be observed with eyes but also does not impair the self-cleaning property of the surface of a coated plate. The surface protective sheet includes: a base material layer; and a pressure-sensitive adhesive layer, in which: the pressure-sensitive adhesive layer has an adhesion for a coated steel plate having a ten-point average surface roughness Rz of 8.0 µm of 0.05 N/20 mm or more; a main component in a pressure-sensitive adhesive for constructing the pressure-sensitive adhesive layer includes a polymer P obtained by cross-linking a polymer A; the polymer A has a weight-average molecular weight Mw of 500,000 or more; the polymer A has a distribution degree Mw/Mn of 8.0 or less; and an insoluble content of the polymer P in ethyl acetate is 90 wt% or more.

## Description

The present invention relates to a surface protective sheet. The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like.

There exist various coated plates such as a coated steel plate ranging from a plate having a smooth surface to a plate having a rough surface, and the attachment of a surface protective sheet to the surface of any such plate has been generally performed for protecting the surface from, for example, a flaw at the time of its conveyance or processing. The surface protective sheet is typically obtained by providing one side of a base material layer with a pressure-sensitive adhesive layer.

A surface protective sheet whose adhesion is excellently prevented from increasing with days has been reported as the surface protective sheet (Japanese Patent Application Laid-open No. 2010-42580). However, the surface protective sheet described in Japanese Patent Application Laid-open No. 2010-42580 involves the following problem. Its pressure-sensitive adhesive is so hard that the sheet is not bonded to a coated plate having a rough surface.

In view of the foregoing, a surface protective sheet which is excellent in pressure-sensitive adhesiveness for a rough surface and is excellently prevented from causing an adhesive residue has been reported (Japanese Patent Application Laid-open No. 2007-270022 and Japanese Patent Application Laid-open No. 2001-106995). When the surface protective sheet described in Japanese Patent Application Laid-open No. 2007-270022 or Japanese Patent Application Laid-open No. 2001-106995 is used for a general-purpose coated plate, the sheet is excellent in pressure-sensitive adhesiveness for a rough surface and no adhesive residue is observed with eyes. Accordingly, the sheet causes no serious problem in practical use.

A hydrophilic coated plate to which a hydrophilic fine particle or a hydrophilic polymer is added has started to become widespread as a new coated plate that replaces a conventional coated plate in recent years. Such hydrophilic coated plate has self-cleaning property and has such a function that even when its surface receives dirt, the dirt can be removed with rainwater or the like. When the surface protective sheet described in Japanese Patent Application Laid-open No. 2007-270022 or Japanese Patent Application Laid-open No. 2001-106995 is used for such hydrophilic coated plate, the sheet shows good pressure-sensitive adhesiveness and no adhesive residue is observed with eyes. However, a pressure-sensitive adhesive residue that cannot be observed with the eyes exists on the surface of the hydrophilic coated plate, and as a result, such a problem that the self-cleaning property of the hydrophilic coated plate after the release of the surface protective sheet disappears arises.

The present invention has been made to solve the above-mentioned conventional problems, and an object of the present invention is to provide a surface protective sheet which satisfactorily adheres even to a coated surface having a rough surface, and not only does not cause an adhesive residue that can be observed with eyes but also does not impair the self-cleaning property of the surface of a coated plate.

A surface protective sheet according to an aspect of the present invention includes: a base material layer; and a pressure-sensitive adhesivelayer,in which:the pressure-sensitive adhesive layer has an adhesion for a coated steel plate having a ten-point average surface roughness Rz of 8.0 µm of 0.05 N/20 mm or more; a main component in a pressure-sensitive adhesive for constructing the pressure-sensitive adhesive layer includes a polymer P obtained by cross-linking a polymer A; the polymer A has a weight-average molecular weight Mw of 500, 000 or more; the polymer A has a distribution degree Mw/Mn of 8.0 or less; and an insoluble content of the polymer P in ethyl acetate is 90 wt% or more.

Further, a surface protective sheet according to another aspect of the present invention includes: a base material layer; and a pressure-sensitive adhesive layer, in which: the pressure-sensitive adhesive layer has an adhesion for a coated steel plate having a ten-point average surface roughness Rz of 8.0 µm of 0.05 N/20 mm or more; a main component in a pressure-sensitive adhesive for constructing the pressure-sensitive adhesive layer includes a polymer P obtained by cross-linking a polymer A; and an area ratio of a weight-average molecular weight Mw of 2,500 or less in GPC measurement of soluble components of the polymer P in ethyl acetate is 50% or more.

In a preferred embodiment, the above-mentioned polymer A includes an acrylic polymer obtained by polymerizing a monomer composition containing a (meth) acrylate monomer as a main component.

In a preferred embodiment, the surface protective sheet of the present invention is used for protecting a surface of a hydrophilic coated plate.

In a preferred embodiment, the surface protective sheet of the present invention is used for protecting a surface of a substrate whose degree of contamination is requested to be low.

In a preferred embodiment, the surface protective sheet of the present invention is used for protecting a substrate having an antireflection film.

In a preferred embodiment, the surface protective sheet of the present invention is used for protecting a surface of a cover glass for a solar cell.

According to the present invention, it is possible to provide the surface protective sheet which satisfactorily adheres even to a coated surface having a rough surface, and not only does not cause an adhesive residue that can be observed with eyes but also does not impair the self-cleaning property of the surface of a coated plate.

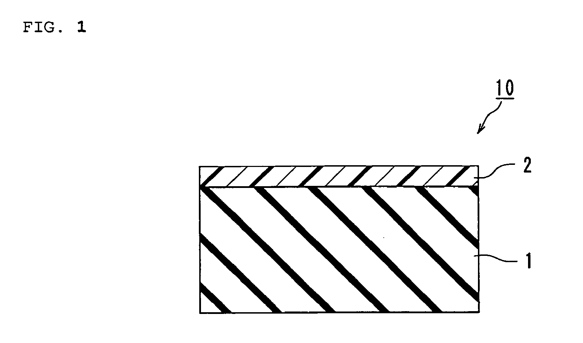

FIG. **1** is a schematic sectional view of a surface protective sheet according to a preferred embodiment of the present invention.

### <<A. Surface protective sheet»

A surface protective sheet of the present invention includes a base material layer and a pressure-sensitive adhesive layer. FIG. **1** is a schematic sectional view of a surface protective sheet according to a preferred embodiment of the present invention. A surface protective sheet **10** includes a base material layer **1** and a pressure-sensitive adhesive layer **2**. The surface protective sheet of the present invention may further have any appropriate other layer as required (not shown).

The surface of the base material layer **1** on which the pressure-sensitive adhesive layer **2** is not provided can be subj ected to a release treatment by adding, for example, a fatty acid amide, a polyethyleneimine, or a long-chain alkyl-based additive to the base material layer, or can be provided with a coat layer formed of any appropriate releasing agent such as a silicone-, long-chain alkyl-, or fluorine-based releasing agent for the purpose of, for example, forming a winding body that can be easily rewound. In addition, separately from the base material, a release liner having releasability may be attached.

The thickness of the surface protective sheet of the present invention can be set to any appropriate thickness depending on applications. The thickness is preferably 10 to 300 µm, more preferably 15 to 250 µm, still more preferably 20 to 200 µm, particularly preferably 25 to 150 µm from the viewpoints of, for example, the prevention of a flaw and an adhesion.

In the surface protective sheet of the present invention, the pressure-sensitive adhesive layer has an adhesion for a coated steel plate having a ten-point average surface roughness Rz of 8.0 µm of 0.05 N/20 mm or more. Here, the "coated steel plate having a ten-point average surface roughness Rz of 8.0 µm" specifies an adherend as a reference upon evaluation of the pressure-sensitive adhesive layer in the surface protective sheet of the present invention for its adhesion. The "ten-point average surface roughness Rz" is a known indicator as an indicator of the roughness of a surface. In the surface protective sheet of the present invention, the pressure-sensitive adhesive layer has an adhesion for the coated steel plate having a ten-point average surface roughness Rz of 8.0 µm of preferably 0.10 to 15 N/20 mm, more preferably 0.10 to 10 N/20 mm, still more preferably 0.15 to 7 N/20 mm, particularly preferably 0.20 to 5 N/20 mm. The surface protective sheet of the present invention can express good pressure-sensitive adhesiveness even for a coated surface having a rough surface as long as the adhesion of the pressure-sensitive adhesive layer for the coated steel plate having a ten-point average surface roughness Rz of 8.0 µm falls within the above-mentioned range.

### <A-1. Base material layer>

Any appropriate thickness can be adopted as the thickness of the base material layer depending on applications. The thickness of the base material layer is preferably 5 to 300 µm, more preferably 10 to 250 µm, still more preferably 15 to 200 µm, particularly preferably 20 to 150 µm.

The base material layer may be a single layer, or may be a laminate of two or more layers. The base material layer may be stretched.

Any appropriate material can be adopted as a material for the base material layer depending on applications. Examples of the material include a plastic, paper, a metal film, and a nonwoven fabric. Of those, a plastic is preferred. The materials may be used alone or in combination to construct the base material layer. For example, the layer may be constructed of two or more kinds of plastics.

Examples of the above-mentioned plastic include a polyester-based resin, a polyamide-based resin, and a polyolefin-based resin. Examples of the polyester-based resin include polyethylene terephthalate, polybutylene terephthalate, and polyethylene naphthalate. Examples of the polyolefin-based resin include a homopolymer of an olefin monomer and a copolymer of olefin monomers . Specific examples of thepolyolefin-basedresin include: homopolypropylene; propylene-based copolymers such as block, random, and graft copolymers each including an ethylene component as a copolymer component; reactor TPO; ethylene-based polymers such as low density, high density, linear low density, and ultra low density polymers; and ethylene-based copolymers such as an ethylene-propylene copolymer, an ethylene-vinyl acetate copolymer, an ethylene-methyl acrylate copolymer, an ethylene-ethyl acrylate copolymer, an ethylene-butyl acrylate copolymer, an ethylene-methacrylic acid copolymer, and an ethylene-methyl methacrylate copolymer.

The base material layer may contain any appropriate additive as required. Examples of the additive that can be contained in the base material layer include an antioxidant, a UV absorbing agent, a light stabilizer, an antistatic agent, a filler, and a pigment. The kind, number, and amount of the additive that can be contained in the base material layer can be appropriately set depending on purposes. In particular, when the material for the base material layer is a plastic, it is preferred to contain some of the above-mentioned additives for the purpose of, for example, preventing deterioration. From the viewpoint of, for example, the improvement of weather resistance, particularly preferred examples of the additive include an antioxidant, a UV absorbing agent, a light stabilizer, and a filler.

Any appropriate antioxidant can be adopted as the antioxidant. Examples of such antioxidant include a phenol-based antioxidant, a phosphorus-based processing heat stabilizer, a lactone-based processing heat stabilizer, a sulfur-based heat stabilizer, and a phenol-phosphorus-based antioxidant. The content of the antioxidant is preferably 1 part by weight or less, more preferably 0.5 part by weight or less, still more preferably 0.01 to 0.2 part by weight with respect to 100 parts by weight of the base resin of the base material layer (when the base material layer is a blend, the blend is the base resin).

Any UV absorbing agent can be adopted as the W absorbing agent. Examples of such UV absorbing agent include a benzotriazole-based W absorbing agent, a triazine-based UV absorbing agent, and a benzophenone-based UV absorbing agent. The content of the UV absorbing agent is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate light stabilizer can be adopted as the light stabilizer. Examples of such light stabilizer include a hindered amine-based light stabilizer and a benzoate-based light stabilizer. The content of the light stabilizer is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate filler can be adopted as the filler. Examples of such filler include an inorganic filler. Specific examples of the inorganic filler include carbon black, titanium oxide, and zinc oxide. The content of the filler is preferably 20 parts by weight or less, more preferably 10 parts by weight or less, still more preferably 0.01 to 10 parts by weight with respect to 100 parts by weight of the base resin that forms the base material layer (when the base material layer is a blend, the blend is the base resin).

Further, a surfactant, an inorganic salt, a polyhydric alcohol, a metal compound, an inorganic antistatic agent such as carbon, and low molecular-weight and high molecular-weight antistatic agents each intended to impart antistatic property are also preferably given as examples of the additive. Of those, a high-molecular weight antistatic agent or carbon is particularly preferred from the viewpoints of contamination and the maintenance of pressure-sensitive adhesiveness.

### <A-2. Pressure-sensitive adhesive layer>

The thickness of the pressure-sensitive adhesive layer is preferably 1 to 100 µm, more preferably 3 to 50 µm, still more preferably 5 to 30 µm, particularly preferably 5 to 20 µm.

The pressure-sensitive adhesive layer is constructed ofapressure-sensitiveadhesive. The pressure-sensitive adhesives maybe used alone or in combination. The pressure-sensitive adhesive preferably contains a polymer P obtained by cross-linking a polymer A as a main component. Specifically, the content of the polymer P in the pressure-sensitive adhesive is preferably 50 wt% or more, more preferably 80 wt% or more, still more preferably 90 wt% or more, particularly preferably 95 wt% or more.

The polymer A has a weight-average molecular weight Mw (in terms of a standard polystyrene) of preferably 500,000 or more, more preferably 520, 000 to 2, 000, 000, still more preferably 550,000 - to 1,500,000. As long as the weight-average molecular weight Mw of the polymer A falls within the above-mentioned range, a surface protective sheet that does not impair the self-cleaning property of the surface of a coated plate can be provided.

The polymer A has a distribution degree Mw/Mn of preferably 8.0 or less, more preferably 2.0 to 7.0, still more preferably 3.0 to 5.0. As long as the distribution degree Mw/Mn of the polymer A falls within the above-mentioned range, a surface protective sheet that does not impair the self-cleaning property of the surface of a coated plate can be provided.

The insoluble content of the polymer P in ethyl acetate is preferably 90 wt% or more, more preferably 95 wt% or more, still more preferably 97 wt% or more. As long as the insoluble content of the polymer P in ethyl acetate falls within the above-mentioned range, a surface protective sheet that does not impair the self-cleaning property of the surface of a coated plate can be provided.

In the surface protective sheet of the present invention, it is particularly preferred that the weight-average molecular weight Mw of the polymer A be 500,000 or more, the distribution degree Mw/Mn of the polymer A be 8.0 or less, and the insoluble content of the polymer P in ethyl acetate be 90 wt% or more for the purpose of providing a surface protective sheet that does not impair the self-cleaning property of the surface of a coated plate and the reflectance of a substrate having an antireflection function.

An area ratio of a weight-average molecular weight Mw of 2,500 or less in the GPC measurement of the soluble components of the polymer P in ethyl acetate is preferably 50% or more, more preferably 60% or more, still more preferably 70% or more. A soluble component having a weight-average molecular weight Mw in excess of 2,500 in the GPC measurement of the soluble components of the polymer P in ethyl acetate may impair the self-cleaning property of the surface of a coated plate.

Any appropriate pressure-sensitive adhesive can be adopted as the pressure-sensitive adhesive for constructing the pressure-sensitive adhesive layer. Examples of such pressure-sensitive adhesive include an acrylic pressure-sensitive adhesive, a silicone-based pressure-sensitive adhesive, and a rubber-based pressure-sensitive adhesive. Of those, an acrylic pressure-sensitive adhesive is particularly preferred as the pressure-sensitive adhesive.

The polymer A before the cross-linking for obtaining the polymer P as a main component in the acrylic pressure-sensitive adhesive is preferably an acrylic polymer obtained by polymerizing a monomer composition containing a (meth) acrylate monomer as a main component. The adoption of such acrylic polymer as the polymer A can provide a surface protective sheet that does not impair the self-cleaning property of the surface of a coated plate. It should be noted that the expression "(meth)acrylate" means at least one of an acrylate and a methacrylate.

The content of the (meth) acrylate monomer in the monomer composition is preferably 50 wt% or more, more preferably 60 to 99 wt%, still more preferably 70 to 98 wt%, particularly preferably 80 to 97 wt%. As long as the content of the (meth) acrylate monomer in the monomer composition falls within the above-mentioned range, a surface protective sheet which satisfactorily adheres even to a coated surface having a rough surface, and not only does not cause an adhesive residue that can be observed with eyes but also does not impair the self-cleaning property of the surface of a coated plate can be provided.

Examples of the (meth) acrylate monomer include methyl (meth)acrylate, ethyl (meth)acrylate, n-butyl (meth)acrylate, s-butyl (meth)acrylate, t-butyl (meth)acrylate, isobutyl (meth)acrylate, hexyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate.

The (meth)acrylate monomers may be used alone or in combination in the monomer composition.

It is preferred that the monomer composition include a functional group-containing monomer for cross-linking. Examples of such functional group-containing monomer include a carboxyl group-containing monomer, an acid anhydride group-containing monomer, a hydroxyl group-containing monomer, an amino group-containing monomer, an epoxy group-containing monomer, an isocyanate group-containing monomer, and an aziridine group-containing monomer. Specific examples of such functional group-containing monomer include (meth)acrylic acid, 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinylether, 4-hydroxybutylvinylether, diethylene glycol monovinyl ether, glycidyl (meth)acrylate, methylglycidyl (meth)acrylate, and allyl glycidyl ether. It should be noted that the expression "(meth)acrylic acid" means at least one of acrylic acid and methacrylic acid, and the expression " (meth) acrylate" means at least one of an acrylate and a methacrylate.

The functional group-containing monomers may be used alone or in combination in the monomer composition.

The content of the functional group-containing monomer in the monomer composition is preferably 1 to 25 wt%, more preferably 1 to 20 wt%, still more preferably 2 to 15 wt%, particularly preferably 3 to 10 wt%. As long as the content of the functional group-containing monomer in the monomer composition falls within the above-mentioned range, a surface protective sheet which satisfactorily adheres even to a coated surface having a rough surface, and not only does not cause an adhesive residue that can be observed with eyes but also does not impair the self-cleaning property of the surface of a coated plate can be provided.

The monomer composition may include, as a monomer for controlling releasability,asulfonic acid group-containing monomer, a phosphoric acid group-containing monomer,a cyano group-containing monomer, a vinyl ester monomer, an aromatic vinyl monomer, an amide group-containing monomer, an imide group-containing monomer, N-acryloylmorpholine, a vinyl ether monomer, or the like. Specific examples of such monomer include styrene, chlorostyrene, chloromethylstyrene, α-methylstyrene, vinyl acetate, and acrylonitrile. The above-mentioned monomers in the monomer composition may be used alone or in combination.

The acrylic pressure-sensitive adhesive capable of constructing the pressure-sensitive adhesive layer has a glass transition temperature (Tg) in the FOX equation of preferably -80 to 0°C, more preferably -70 to -10°C, still more preferably -60 to -20°C. As long as the glass transition temperature (Tg) falls within the above-mentioned range, a surface protective sheet that can satisfactorily adhere even to a coated surface having a rough surface canbeprovided. It shouldbe noted that the glass transition temperature (Tg) can be adjusted by appropriately changing monomer components to be used and their composition ratio.

The polymer P is obtained by cross-linking the polymer A. That is, examples of the polymer P include a cross-linkedpolymer obtained by causing the polymer A and any appropriate cross-linking agent to react with each other, and a cross-linked polymer obtained by irradiating the polymer A with an active energy ray (such as ultraviolet light or an electron beam) to subject the polymer to a cross-linking reaction.

Any appropriate cross-linking agent can be adopted as a cross-linking agent that can be used for cross-linking the polymer A to provide the polymer P. Examples of such cross-linking agent include an epoxy-based cross-linking agent, a polyfunctional isocyanate-based cross-linking agent, a melamine resin-based cross-linking agent, a metal salt-based cross-linking agent, a metal chelate-based cross-linking agent, an amino resin-based cross-linking agent, and a peroxide-based cross-linking agent. It should be noted that a cross-linked structure can be constructed by the application of an active energy ray such as ultraviolet light or an electron beam as well irrespective of whether the cross-linking agent is used. The cross-linking agents may be used alone or in combination.

The usage of the cross-linking agent is preferably 20 parts by weight or less, more preferably 10 parts by weight or less, still more preferably 1 to 8 parts by weight with respect to 100 parts by weight of thepolymerAbefore the cross-linking for obtaining the polymer P as the main component of the pressure-sensitive adhesive. When the content of the cross-linking agent deviates from the above-mentioned range, the cross-linking agent itself may be responsible for contamination.

Examples of the cross-linking agent to be particularly preferably used include an epoxy-based cross-linking agent and a polyfunctional isocyanate-based cross-linking agent.

A polyfunctional epoxy compound is preferably used as the epoxy-based cross-linking agent, and includes various compounds each having two or more epoxy groups in the molecule. Representative examples thereof include sorbitol tetraglycidyl ether, trimethylolpropane glycidyl ether, tetraglycidyl-1,3-bisaminomethylcyclohexane, tetraglycidyl-m-xylenediamine, and triglycidyl-p-aminophenol.

A polyfunctional isocyanate compound is preferably used as the isocyanate-based cross-linking agent, and includes various compounds each including two or more isocyanate groups in the molecule. Representative examples thereof include diphenylmethane diisocyanate, tolylene diisocyanate, and hexamethylene diisocyanate.

Any appropriate additive can be contained in the pressure-sensitive adhesive for constructing the pressure-sensitive adhesive layer. Examples of such additive include a softener, a tackifier, a surface lubricating agent, a leveling agent, an antioxidant, a corrosion inhibitor, a light stabilizer, a UV absorbing agent, a heat stabilizer, a polymerization inhibitor, a silane coupling agent, a lubricant, an inorganic or organic filler, a metal powder, a pigment, and a solvent.

The tackifier is effective in improving an adhesion, in particular, improving pressure-sensitive adhesiveness for an adherend having a rough surface. Any appropriate tackifier can be adopted as the tackifier. Examples of such tackifier include petroleum-based resins such as an aliphatic copolymer, an aromatic copolymer, an aliphatic-aromatic copolymer system, and an alicyclic copolymer, a coumarone-indene-based resin, a terpene-based resin, a terpene phenol-based resin, a rosin-based resin such as a polymerized rosin, an (alkyl) phenol-based resin, a xylene-based resin, and hydrogenated products thereof. The tackifiers may be used alone or in combination.

The content of the tackifier is preferably 50 parts by weight or less, more preferably 30 parts by weight or less, still more preferably 10 parts by weight or less with respect to 100 parts by weight of the polymer P as the main component of the pressure-sensitive adhesive. When the content of the tackifier deviates from the above-mentioned range, pressure-sensitive adhesiveness at low temperatures may be poor or an adhesive residue at high temperatures may be remarkable.

The pressure-sensitive adhesive for constructing the pressure-sensitive adhesive layer can be produced by any appropriate method. The pressure-sensitive adhesive for constructing the pressure-sensitive adhesive layer can be produced, for example, as described below. While a polymerization method to be generally employed as an approach to synthesizing a polymer, such as solution polymerization, emulsion polymerization, bulk polymerization, suspension polymerization, or polymerization with ultraviolet light (UV) is employed, any appropriate cross-linking method is adopted, and any appropriate additive is used as required.

Of the polymerization methods, solution polymerization, emulsion polymerization, suspension polymerization, or polymerization with ultraviolet light (UV) is preferred because a pressure-sensitive adhesive having a high molecular weight and a low distribution degree can be produced. With regard to, for example, the solution polymerization, a polymerization initiator and a solvent are added to the monomer composition, and any appropriate additive is added to the mixture as required so that the solution polymerization may be performed.

Any appropriate polymerization initiator can be adopted as the polymerization initiator. Examples of such polymerization initiator include an azo-based compound and a peroxide. Specific examples of such polymerization initiator include 2,2'-azobisisobutyronitrile, 2,2'-azobisisovaleronitrile, 2,2'-azobis(4-methoxy-2,4-dimethylvaleronitrile),
2,2'-azobis(2,4-dimethylvaleronitrile),
2,2'-azobis(2-methylbutyronitrile),
1,1'-azobis(cyclohexane-1-carbonitrile),
2,2'-azobis(2,4,4-trimethylpentane),
dimethyl-2,2'-azobis(2-methylpropionate), benzoyl peroxide,
t-butyl hydroperoxide, di-t-butyl hydroperoxide, t-butyl peroxybenzoate, dicumyl peroxide, 1,1-bis(t-butylperoxy)-3,3,5-trimethylcyclohexane, and 1,1-bis(t-butylperoxy)cyclododecane.

### <<B. Method of producing surface protective sheet»

The surface protective sheet of the present invention can be produced by any appropriate method. The production can be performed in conformity with, as suchproductionmethod, any appropriate method of producing a pressure-sensitive adhesive sheet, such as:
(1) a method involving applying a solution of the pressure-sensitive adhesive in a solvent or a hot-melt liquid thereof to the base material;
(2) a method involving transferring the pressure-sensitive adhesive layer applied and formed in a separator fashion in conformity with the foregoing;
(3) a method involving extruding a material for forming the pressure-sensitive adhesive layer onto the base material to form and apply the layer;
(4) a method involving extruding the base material and the pressure-sensitive adhesive layer in two layers or a plurality of layers;
(5) a method involving laminating a single layer of the pressure-sensitive adhesive layer onto the base material or a method involving laminating two layers of a laminate layer and the pressure-sensitive adhesive layer; or
(6) a method involving laminating two layers, or a plurality of layers, of the pressure-sensitive adhesive layer and a material for forming the base material such as a film or a laminate layer.

Examples of the above-mentioned application method include methods each involving the use of a bar coater, a gravure coater, a spin coater, a roll coater, a knife coater, or an applicator.

The method involving applying a solution of the pressure-sensitive adhesive in a solvent or a hot-melt liquid thereof to the base material is particularly preferred as the method of producing the surface protective sheet of the present invention in terms of productivity and a cost.

### «C. Applications of surface protective sheet»

The surface protective sheet of the present invention satisfactorily adheres even to a coated surface having a rough surface, and not only does not cause an adhesive residue that can be observed with eyes but also does not impair the self-cleaning property of the surface of a coated plate. Accordingly, the surface protective sheet of the present invention can be used in any appropriate application. The surface protective sheet can be preferably used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like. More specifically, the surface protective sheet of the present invention can be suitably used in an application such as the protection of the surface of a hydrophilic coated plate, the protection of the surface of a substrate whose degree of contamination is requested to be low, the protection of a substrate having an antireflection film, or the protection of the surface of a cover glass for a solar cell.

Hereinafter, the present invention is described specifically by way of examples. However, the present invention is by no means limited to these examples. It should be noted that test and evaluation methods in the examples and the like are as described below. In addition, the term "part(s)" means "part(s) by weight."

### (Ten-point average surface roughness Rz)

The surface roughness of the front surface of a hydrophilic coated steel plate (A02W APPEARCLEAN (white) manufactured by JFE Galvanizing & Coating Co., Ltd.) was measured with an optical profiler NT9100 (manufactured by Veeco) under the conditions "Measurement Type: VSI (Infinite Scan), Objective: 2.5X, FOV: 1.0X, Modulation Threshold: 0.1%" for n=3. After the measurement, data analysis was performed under the conditions "Terms Removal: Tilt Only (Plane Fit), Window Filtering: None" to determine the ten-point average surface roughness Rz.

### (Adhesion for coated steel plate having ten-point average surface roughness Rz of 8.0 µm)

An adhesion was measured in conformity with JIS Z0237 (2000) That is, a surface protective sheet under test was attached to a coated steel plate having a ten-point average surface roughness Rz of 8.0 µm at a linear pressure of 78.7 N/cm, and after a lapse of 30 minutes from the attachment, its adhesion was measured with an Instron tensile tester (AUTOGRAPH manufactured by Shimadzu Corporation) under the conditions of a release angle of 180° and a tension speed of 0.3 m/min.

### (Weight-average molecular weight Mw and distribution degree Mw/Mn)

A weight-average molecular weight Mw and a distribution degree Mw/Mn were measured by a gel permeation chromatography method (GPC method) with an HLC-8120 (manufactured by TOSOH CORPORATION) as described below. The measurement was performed by using columns each having an inner diameter of 6.0 mm and a length of 150 mm (TSKgel SuperHZM-H/HZ4000/HZ3000/HZ2000 manufactured by TOSOH CORPORATION), the columns being connected in series, and tetrahydrofuran as an eluent under the conditions of a concentration of 1 g/L, a flow rate of 0.6 ml/min, a temperature of 40°C, and a sample injection amount of 20 µl. An RI detector was used as a detector. In addition, a TSK standard polystyrene (manufactured by TOSOH CORPORATION) was used for creating a molecular weight calibration curve.

### (Insoluble content in ethyl acetate)

About 0.1 g of a polymer (after a cross-linking reaction) was recovered and wrapped with a porous tetrafluoroethylene sheet having an average pore diameter of 0.2 µm (trade name "NTF1122 , " manufactured by Nitto Denko Corporation) . After that, the wrapped product was bound with a kite string and the weight of the resultant at that time was measured. The weight was defined as a weight before immersion. It should be noted that the weight before immersion is the total weight of the polymer (recovered in the foregoing), the tetrafluoroethylene sheet, and the kite string. The total weight of the tetrafluoroethylene sheet and the kite stringwas also measured, and the weight was defined as a tare weight.
Next, the product obtained by wrapping the above-mentioned polymer with the tetrafluoroethylene sheet and binding the wrapped product with the kite string (referred to as "sample") was placed in a 50-ml container filled with ethyl acetate, and was then left at rest at 23°C for 7 days.
After that, the sample (after having been treated with ethyl acetate) was taken out of the container and transferred to an aluminum cup. The sample was dried in a dryer at 130°C for 2 hours so that ethyl acetate was removed. After that, the weight of the remainder was measured, and the weight was defined as a weight after immersion.
A solvent insoluble content was calculated from the following equation.
Solvent insoluble content (wt%)=(a-b)/(c-b)x100 (1)
It should be noted that in the equation (1), a represents the weight after immersion, b represents the tare weight, and c represents the weight before immersion.

(Area ratio of weight-average molecular weight Mw of 2,500 or less in GPC measurement of soluble components in ethyl acetate)
An ethyl acetate soluble component was subj ected to measurement by the GPC method described above after ethyl acetate had been dried with a vacuum dryer. An area ratio was calculated from the result of the measurement by GPC as described below.
Area ratio (%) =(area of weight-average molecular weight of 2,500 or less (including eluent) /area of entirety (ethyl acetate soluble components))x100
In addition, upon recovery of the polymer (after the cross-linking reaction), the polymer may be recovered from the pressure-sensitive adhesive surface of the surface protective sheet, or may be recovered from a product obtained by separately applying the same polymer as that provided for the surface protective sheet to a silicone liner or the like and drying the applied polymer.

### (Rain line contamination property)

A hydrophilic coated steel plate (100x200x0.3 mm) to which the resultant surface protective sheet had been attached was mounted on an outdoor exposure stage having a south exposure angle of 45°, and was then subjected to an exposure test at the rooftop of Nitto Denko Corporation in Toyohashi-shi, Aichi Prefecture for one month. After that, the surface protective sheet was released, and then the remainderwas subj ected to the same exposure test for anadditional one month. After that, rain line contamination property (rain line-like dirt mark) was visually observed at the time of a fine weather.
Evaluation criteria for the rain line contamination property are as described below.
o : No rain line mark is observed or a rain line mark is slightly observed.
× : A rain line mark remains.

### (Production Example 1): Production of base material 1

A mixture obtained by blending 3 parts of titanium oxide (FTR-700 manufactured by Sakai Chemical Industry Co., Ltd.) and 0.1 part of a hindered amine-based light stabilizer (CHIMASSORB 2020manufacturedbyBASF) with respect to 100 parts of a polyethylene resin (Petrocene 183 manufactured by TOSOH CORPORATION) was formed into a film by an inflation method so that a die temperature was 160°C. Thus, a base material 1 having a thickness of 55 µm was obtained.

### (Production Example 2): Production of base material 2

A mixture obtained by blending 9 parts of titanium oxide (FTR-700 manufactured by Sakai Chemical Industry Co., Ltd.) with respect to 100 parts of a propylene resin (Prime Polypro F-744NPT manufactured by Prime Polymer Co., Ltd.) was formed into a film by a T-die method so that a die temperature was 230°C. Thus, a base material 2 having a thickness of 50 µm was obtained.

### (Production Example 3): Production of polymer A(1)

A mixed solution of 97 parts of butyl acrylate and 3 parts of acrylic acid, 0.20 part of 2,2'-azobisisobutyronitrile as a polymerization initiator, and 200 parts of ethyl acetate were loaded into a reaction vessel provided with a cooling tube, a nitrogen-introducing tube, a temperature gauge, and a stirring apparatus, and then the mixture was subjected to polymerization at 60°C for 12 hours. Thus, a solution of apolymerA(1) was obtained. The resultant polymer A(1) had a weight-average molecular weight Mw of 1,000,000 and a distribution degree Mw/Mn of 3.9.

### (Production Example 4): Production of polymer A(2)

A solution of a polymer A(2) was obtained in the same manner as in Production Example 3 except that a mixed solution of 95 parts of butyl acrylate and 5 parts of acrylic acid, 0.40 part of 2,2'-azobisisobutyronitrile as a polymerization initiator, and 300 parts of ethyl acetate were used. The resultant polymer A(2) had a weight-average molecular weight Mw of 600, 000 and a distribution degree Mw/Mn of 4.0.

### (Production Example 5): Production of polymer A (3)

A mixed solution of 95 parts of butyl acrylate and 5 parts of acrylic acid, 0.20 part of benzoyl peroxide as a polymerization initiator, and 300 parts of toluene were loaded into a reaction vessel provided with a cooling tube, a nitrogen-introducing tube, a temperature gauge, and a stirring apparatus, and then the mixture was subjected to polymerization at 60°C until a polymerization ratio reached 90%. When the polymerization ratio reached 90%, the temperature was increased to 90°C, and then the resultant was subjected to polymerization for 2 hours. Thus, a solution of a polymer A(3) was obtained. The resultant polymer A(3) had a weight-average molecular weight Mw of 490,000 and a distribution degree Mw/Mn of 15.5.

### (Production Example 6): Production of polymer A(4)

A solution of a polymer A (4) was obtained in the same manner as in Production Example 5 except that a mixed solution of 56 parts of butyl acrylate, 40 parts of ethyl acrylate, and 4 parts of acrylic acid, 0.20 part of benzoyl peroxide as a polymerization initiator, and 200 parts of toluene were used. The resultant polymer A(4) had a weight-average molecular weight Mw of 1, 300, 000 and a distribution degree Mw/Mn of 8.1.

### (Production Example 7): Production of polymer A(5)

A solution of a polymer A (5) was obtained in the same manner as in Production Example 3 except that a mixed solution of 57 parts of 2-ethylhexyl acrylate, 40 parts of vinyl acetate, and 3 parts of acrylic acid, 0.15 part of 2,2'-azobisisobutyronitrile as a polymerization initiator, and 300 parts of toluene were used. The resultant polymer A(5) had a weight-average molecular weight Mw of 460,000 and a distribution degree Mw/Mn of 11.5.

### (Example 1)

A mixed solution prepared by adding 2.0 parts of an epoxy-based cross-linking agent ((TETRAD C manufactured by Mitsubishi Gas Chemical Company, Inc.) to 100 parts of the solid content of the polymer A (1) was applied to the base material 1 one surface of which had been subjected to a corona treatment so that the thickness of a pressure-sensitive adhesive layer after drying was 15 µm. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (1) thus obtained provided with the pressure-sensitive adhesive layer (1) constructed of a pressure-sensitive adhesive containing a polymer P (1) obtained by cross-linking the polymer A (1) as a main component.

### (Example 2)

A mixed solution prepared by adding 4.0 parts of an epoxy-based cross-linking agent (TETRAD C manufactured by Mitsubishi Gas Chemical Company, Inc.) to 100 parts of the solid content of the polymer A(2) was applied to a polyester film having a thickness of 25 µm (Lumirror S10 manufactured by Toray Industries, Inc.) one surface of which had been subjected to a corona treatment so that the thickness of a pressure-sensitive adhesive layer after drying was 10 µm. Thus, a surface protective sheet was produced. In addition, conditions at the time of the dryingwere 85°C and 5 minutes. The resultant surface protective sheet was attached to a polyethylene film, and then the resultant was left to stand at 40°C for 2 days. Table 1 shows the results of the evaluations of the surface protective sheet (2) thus obtained provided with the pressure-sensitive adhesive layer (2) constructed of a pressure-sensitive adhesive containing a polymer P(2) obtained by cross-linking the polymer A(2) as a main component.

### (Example 3)

A mixed solution prepared by adding 2.0 parts of an epoxy-based-cross-linking agent (TETRAD C manufactured by Mitsubishi Gas Chemical Company, Inc.) and 1.0 part of an isocyanate cross-linking agent (Coronate L manufactured by Nippon Polyurethane Industry Co., Ltd.) to 100 parts of the solid content of the polymer A(1) was applied to the base material 2 so that the thickness of a pressure-sensitive adhesive layer after drying was 15 µm. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (3) thus obtained provided with the pressure-sensitive adhesive layer (3) constructed of a pressure-sensitive adhesive containing a polymer P (3) obtained by cross-linking the polymer A (1) as a main component.

### (Comparative Example 1)

A mixed solution prepared by adding 3.0 parts of an epoxy-based cross-linking agent (TETRAD C manufactured by Mitsubishi Gas Chemical Company, Inc.) to 100 parts of the solid content of the polymer A (3) was applied to the base material 1 one surface of which had been subjected to a corona treatment so that the thickness of a pressure-sensitive adhesive layer after drying was 5 µm. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (C1) thus obtained provided with the pressure-sensitive adhesive layer (C1) constructed of a pressure-sensitive adhesive containing a polymer P(C1) obtained by cross-linking the polymer A(3) as a main component.

### (Comparative Example 2)

A mixed solution prepared by adding 5.0 parts of an epoxy-based cross-linking agent (TETRAD C manufactured by Mitsubishi Gas Chemical Company, Inc.) to 100 parts of the solid content of the polymer A (4) was applied to the base material 1 one surface of which had been subjected to a corona treatment so that the thickness of a pressure-sensitive adhesive layer after drying was 8 µm. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (C2) thus obtained provided with the pressure-sensitive adhesive layer (C2) constructed of a pressure-sensitive adhesive containing a polymer P(C2) obtained by cross-linking the polymer A(4) as a main component.

### (Comparative Example 3)

A mixed solution prepared by adding 2.0 parts of an epoxy-based cross-linking agent (TETRAD C manufactured by Mitsubishi Gas Chemical Company, Inc.) to 100 parts of the solid content of the polymer A (5) was applied to the base material 1 one surface of which had been subjected to a corona treatment so that the thickness of a pressure-sensitive adhesive layer after drying was 10 µm. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (C3) thus obtained provided with the pressure-sensitive adhesive layer (C3) constructed of a pressure-sensitive adhesive containing a polymer P(C3) obtained by cross-linking the polymer A(5) as a main component.

**[Table 1]**

| | Adhesion of pressure-sensitive adhesive layer for coated steel plate having ten-point average surface roughness Rz of 8.0 µm (N/20 mm) | Weight-average molecular weight of polymer A | Distribution degree of polymer A | Insoluble content of polymer P in ethyl acetate (wt%) | Area ratio of weight-average molecular weight Mw of 2,500 or less in GPC measurement of soluble components of polymer P in ethyl acetate (%) | Rain line contamination property |
|---|---|---|---|---|---|---|
| Example 1 | 0.76 | 1,000,000 | 3.9 | 99.0 | 61 | o |
| Example 2 | 0.13 | 600,000 | 4.0 | 99.1 | 73 | o |
| Example 3 | 0.60 | 1,000,000 | 3.9 | 99.3 | 70 | o |
| Comparative Example 1 | 0.24 | 490,000 | 15.5 | 94.2 | 45 | × |
| Comparative Example 2 | 0.19 | 1,300,000 | 8.1 | 98.6 | 48 | × |
| Comparative Example 3 | 0.85 | 460,000 | 11.5 | 88.1 | 15 | × |

As is apparent from Table 1, the surface protective sheet of the present invention satisfactorily adheres even to a coated surface having a rough surface, and not only does not cause an adhesive residue that can be observed with eyes but also does not impair the self-cleaning property of the surface of a coated plate.

The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet for a hydrophilic member such as a hydrophilic coated plate, a substrate with an antireflection function formed so as to have a thickness corresponding to a quarter of a wavelength to be prevented from reflecting, a substrate with an antireflection function based on a nano-level uneven structure, or the like.

## Claims

1. A surface protective sheet, comprising:
a base material layer; and
a pressure-sensitive adhesive layer,
wherein:
the pressure-sensitive adhesive layer has an adhesion for a coated steel plate having a ten-point average surface roughness Rz of 8.0 µm of 0.05 N/20 mm or more;
a main component in a pressure-sensitive adhesive for constructing the pressure-sensitive adhesive layer comprises a polymer P obtained by cross-linking a polymer A;
the polymer A has a weight-average molecular weight Mw of 500,000 or more;
the polymer A has a distribution degree Mw/Mn of 8.0 or less;
and
an insoluble content of the polymer P in ethyl acetate is 90 wt% or more.

2. A surface protective sheet, comprising:
a base material layer; and
a pressure-sensitive adhesive layer,
wherein:
the pressure-sensitive adhesive layer has an adhesion for a coated steel plate having a ten-point average surface roughness Rz of 8.0 µm of 0.05 N/20 mm or more;
a main component in a pressure-sensitive adhesive for constructing the pressure-sensitive adhesive layer comprises a polymer P obtained by cross-linking a polymer A; and
an area ratio of a weight-average molecular weight Mw of 2,500 or less in GPC measurement of soluble components of the polymer P in ethyl acetate is 50% or more.

3. A surface protective sheet according to claim 1 or 2, wherein the polymer A comprises an acrylic polymer obtained by polymerizing a monomer composition containing a (meth) acrylate monomer as a main component.

4. A surface protective sheet according to any one of claims 1 to 3, wherein the sheet is used for protecting a surface of a hydrophilic coated plate.

5. A surface protective sheet according to any one of claims 1 to 3, wherein the sheet is used for protecting a surface of a substrate whose degree of contamination is requested to be low.

6. A surface protective sheet according to any one of claims 1 to 3, wherein the sheet is used for protecting a surface of a substrate having an antireflection film.

7. A surface protective sheet according to any one of claims 1 to 3, wherein the sheet is used for protecting a surface of a cover glass for a solar cell.
